# EUROPÄISCHE PATENTSCHRIFT

(11) **EP 0 492 325 B1**
(45) Veröffentlichungstag und Bekanntmachung des Hinweises auf die Patenterteilung: **11.06.1997**
(21) Anmeldenummer: 91121463.3
(22) Anmeldetag: 14.12.1991
(51) Int. Cl.: G11B 20/14, H03M 5/16, H04L 1/24

(54) **Verfahren und Schaltung zur Regenerierung des binären Bitstroms aus einem ternären Signal**
Method and circuit for the regeneration of a binary bitstream from a ternary signal
Procédé et circuit de régénération d'un flux d'information binaire à partir d'un signal ternaire

(30) Priorität: 24.12.1990 DE 4041717
(43) Veröffentlichungstag der Anmeldung: 01.07.1992
(73) Patentinhaber: DEUTSCHE THOMSON-BRANDT GMBH, 78048 Villingen-Schwenningen (DE)
(72) Erfinder: Scholz, Werner, Dipl.-Ing., W-3007 Gehrden (DE)

(56) Entgegenhaltungen:
- EP-A- 0 092 216
- FR-A- 2 511 170
- IEEE TRANSACTIONS ON COMMUNICATIONS. Bd. COM34, Nr. 5, Mai 1986, NEW YORK US Seiten 454 - 461 R. WOOD ET AL. 'Viterbi Detection of Class IV Partial Response on a Magnetic Recording Channel'

## Beschreibung

Die Erfindung geht aus von einem Verfahren gemäß dem Oberbegriff des Anspruchs 1. Ein derartiges Verfahren wird z.B. bei der "Viterbi Detection" angewendet und ist näher beschrieben in "IEEE Transactions on Communications", Vol. Com-34, Nr. 5, May 1986, Seite 454 - 461. Bei dieser bekannten Bitregenerierung wird gegenüber Schaltungen mit einem reinen Schwellwertdetektor eine Verringerung der Fehlerrate erreicht, die einer Verbesserung des Störabstandes in der Größenordnung von 1 - 3 db entspricht.

Aus der FR 2 511 170 ist eine Decoderschaltung für codierte ternäre digitale Datensignale bekannt. Die Schaltung ist hauptsächlich für die Auswertung von auf magnetischen Medien gespeicherten Daten vorgesehen. In der Schaltung werden die Schwellwerte zur Auswertung der Datensignale ständig angepaßt. Wenn die Signalamplitude unter einen bestimmten Normalwert fällt, wird das Signal kompensiert. Nach Gleichrichtung der Signale werden die Signale zwei Abtast/Haltegliedern zugeführt. Deren Signale werden gefiltert und verstärkt. Diese Signale werden dann benutzt, um positiv und negativ angepaßte Schwellwerte zu erzeugen.

Der Erfindung liegt die Aufgabe zugrunde, ein Verfahren für die Regenerierung des binären Signals anzugeben, das wie die genannte bekannte Regenerierung gegenüber einem Schwellwertdetektor eine erhöhte Störsicherheit aufweist, aber mit einfacheren Schaltungen realisierbar ist.

Diese Aufgabe wird durch die im Anspruch 1 angegebene Erfindung gelöst. Vorteilhafte Weiterbildungen und Schaltungen zur Durchführung des Verfahrens sind in den Unteransprüchen angegeben.

Das erfindungsgemäße Verfahren ermöglicht also Schaltungen, die hinsichtlich Fehlerrate bzw. Störabstand die Vorteile der bekannten Viterbi-Detection aufweisen, jedoch mit einem geringeren Schaltungsaufwand auskommen.

Die bekannte Viterbi-Detection und die Erfindung werden im folgenden anhand der Zeichnung erläutert. Darin zeigen
- Fig. 1: ein Blockschaltbild der Gesamtanordnung,
- Fig. 2: Kurven zur Erläuterung der bei der Bandabtastung und Bitregenerierung auftretenden Signale,
- Fig. 3: ein Blockschaltbild einer erfindungsgemäßen Schaltung,
- Fig. 4: ein Auszug aus Fig. 3,
- Fig. 5: Kurvenformen zur Erläuterung der Wirkungsweise der Schaltungen gemäß Fig. 3, 4 und
- Tab. 1: eine Codetabelle des in Fig. 3 verwendeten A/D-Wandlers,
- Fig. 6,7,8: Erläuterungen zur Entstehung des sogenannten PR4-Signals,
- Fig. 9: ein Schaltungsbeispiel für die Weiterbildung der Erfindung für ein PR4-Signal
- Fig. 10: einen Auszug aus der Schaltung gemäß Fig. 9.

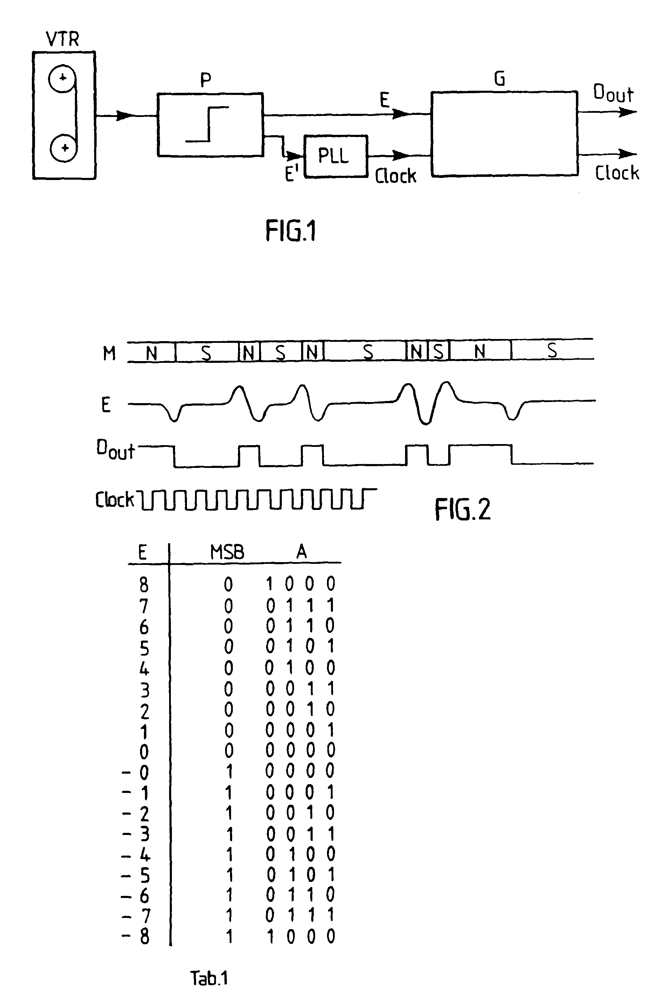

Fig. 1 zeigt das Blockschaltbild einer Schaltung zur Wiedergewinnung des auf einem magnetischen Träger aufgezeichneten Bitstroms und Fig. 2 die zugehörigen Signalverläufe. Die Magnetspur M enthält das Bitmuster in binärer Form, d.h. in Form entgegengesetzt magnetisierter Bereiche, wie durch die Symbole N (Nordpol) und S (Südpol) angedeutet ist. Im Wiedergabekopf wird durch die Flußänderungen zwischen den Bereichen N und S oder S und N die Wiedergabespannung induziert. Diese Spannung stellt etwa das differenzierte Bitmuster dar. Die durch die Magnetisierungsübergänge erzeugten Impulse werden in der Entzerrungsschaltung P verschmälert bzw. von Einflüssen benachbarter Bits befreit. Die Gewinnung des ursprünglichen Bitstroms aus dem entzerrten Signal E im Schaltungsteil G kann auf verschiedene Weise erfolgen, z.B. durch Integration, Nulldurchgangsdetektion und Abtastung mit dem mit einer PLL-Schaltung regenerierten Bittakt. Der Vorteil dieses Verfahrens besteht darin, daß durch die Integration aus dem ternären Signal E ein Signal erzeugt wird, dessen Auswertung mit dem Nulldurchgangdetektor weitgehend pegelunabhängig ist. Sofern das binäre Signal sehr tieffrequente Spektralanteile und große Runlength-Werte enthält, ist es günstiger, das ternäre Signal E direkt mit einem Pegelentscheider auszuwerten. Als Pegelentscheider kann z.B. ein Schmitt-Trigger dienen, der abwechselnd die positiven und negativen Impulse erfaßt. Um die optimalen Triggerpunkte einzuhalten, ist allerdings eine automatische Verstärkungsregelung für das ternäre Signal E erforderlich. Das binäre Ausgangssignal des Schmitt-Triggers wird zur Bestimmung der endgültigen Lage der Pegelübergänge mit dem regenerierten Bittakt abgetastet. Eine Verbesserung der Störsicherheit kann bei der Signalauswertung mit der eingangs erwähnten bekannten Viterbi Detection des ternären Signals E erzielt werden. Bei dieser bekannten Schaltung wird das Signal vorzugsweise in zwei Schaltungszweigen verarbeitet. Hierzu wird das Signal mit zwei A/D-Wandlern abwechselnd abgetastet. Außer dem A/D-Wandler enthält jeder Zweig verschiedene Register, Comparatoren, Addierer sowie ein RAM mit Adressiereinrichtung.

In folgenden wird eine Schaltung zur Regenerierung des Bitstromes aus dem ternären Signal beschrieben, die ebenfalls gegenüber dem einfachen Pegelentscheider eine erhöhte Störsicherheit aufweist, jedoch mit einem wesentlich geringeren Schaltungsaufwand auskommt. Außer einem A/D-Wandler werden nur einige Register und zwei Comparatoren benötigt.

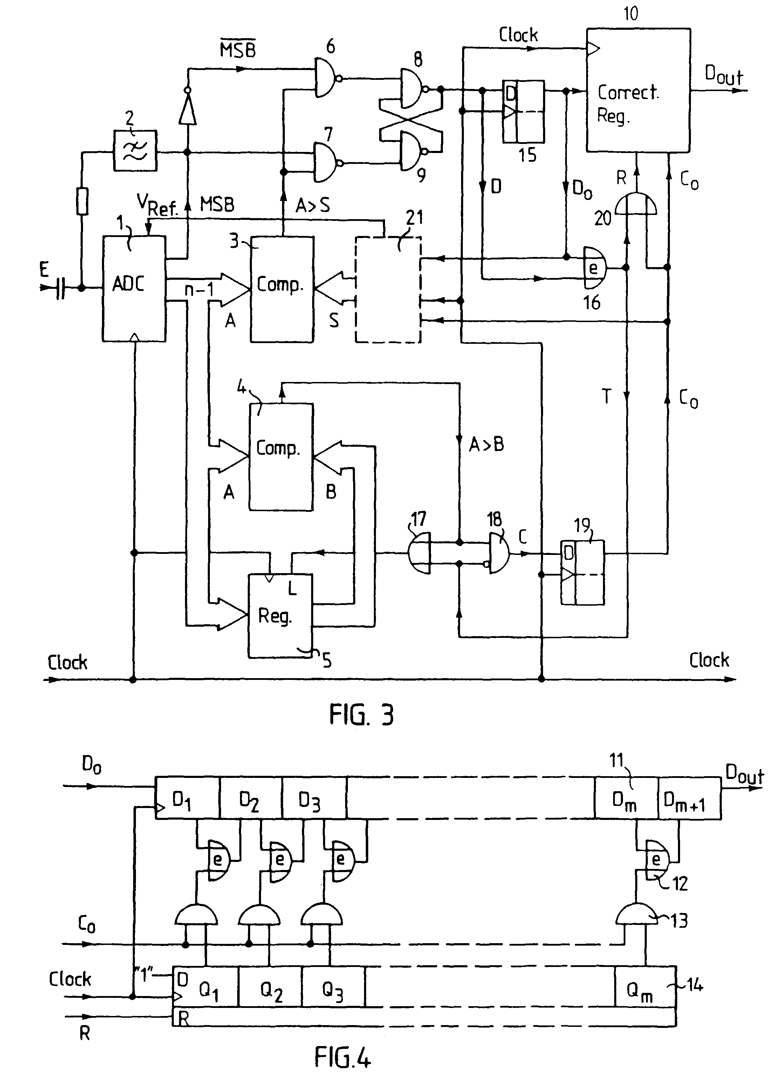

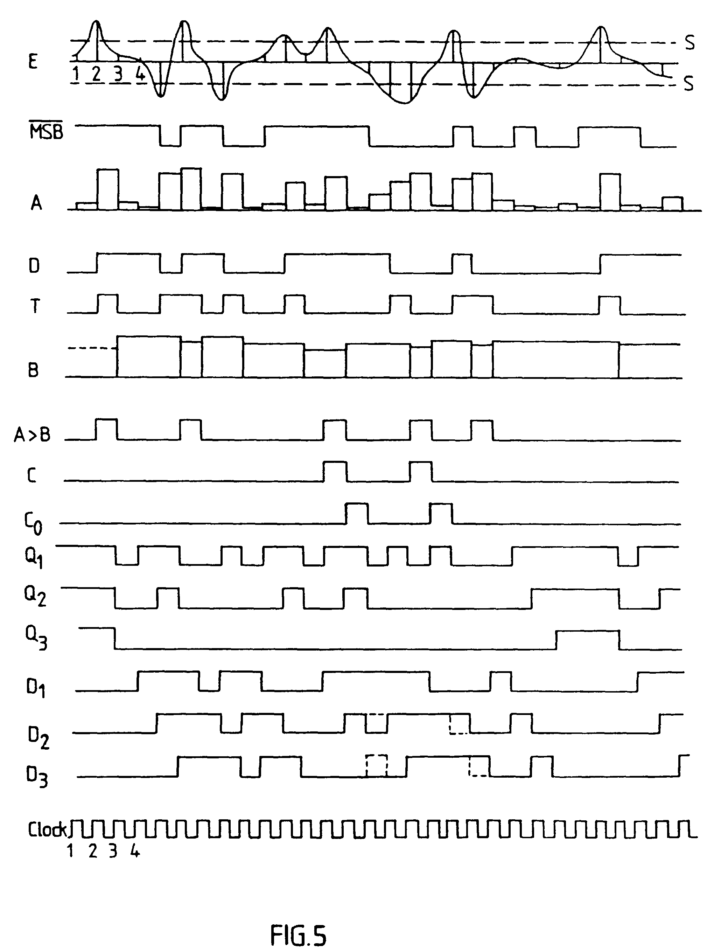

Fig. 3 zeigt das Blockschaltbild eines derartigen Bitstromregenerators, Fig. 5 einige zugehörige Signalverläufe. Das entzerrte ternäre Signal E wird mit Hilfe des regenerierten Bittaktes durch den A/D-Wandler 1 abgetastet. Die Abtastzeitpunkte werden durch die Phasenregelung der Taktregenerierungsschaltung(PLL) etwa auf die Impulsspitzen des Signals E eingestellt.

Tabelle 1 zeigt ausschnittsweise die Tabelle für den digitalen Ausgangscode des hier verwendeten A/D-Wandlers. Das MSB stellt dabei das Vorzeichen dar, während die restlichen n-1 Bit den Betrag A der Abtastwerte angeben. Es ist zweckmäßig, das MSB (most significant bit) für die Vorspannungsregelung am Eingang des A/D-Wandlers auszunutzen. Dazu wird über den Tiefpaß 2 eine aus dem Mittelwert der MSB's erzeugte und verstärkte Spannung auf den A/D-Wandler-Eingang zurückgeführt. Die Einstellung ist dabei so, daß die "0" und die "1" etwa mit gleicher Häufigkeit als MSB auftreten.

Die Komparatoren 3 und 4 untersuchen jeweils nur den Betrag A der Abtastwerte. Dabei stellt der Komparator 3 fest, ob der Abtastwert A einen vorgegebenen Schwellwert S überschreitet. Der Komparator 4 dient zur Ermittlung des maximalen Abtastwertes bis zur nächsten Schwellwertüberschreitung mit entgegengesetztem Vorzeichen. Der jeweils ermittelte Maximalwert wird in dem Register 5 abgespeichert.

Bei jeder Schwellwertüberschreitung liefern die Ausgänge der Gatter 6 und 7 in Abhängigkeit vom Vorzeichen (MSB) einen negativen Impuls auf einen der Eingänge des aus den Gattern 8 und 9 gebildeten R-S-Flip-Flops. Das Ausgangssignal D des Flip-Flops 8, 9 entspricht dem mit einem einfachen Schwellwertdetektor regenerierten Signal. Die Pegelübergänge des Signals D treten dann auf, wenn die erste Schwellwertüberschreitung mit geändertem Vorzeichen erfolgt. Bei störungsfreiem Signal E haben aufeinanderfolgende Schwellwertüberschreitungen wechselndes Vorzeichen, d.h. jeder Abtastwert A, der den Schwellwert S übersteigt, gehört zu einem Pegelübergang des ursprünglichen Bitstromes. Bei aufeinanderfolgenden Schwellwertüberschreitungen mit gleichem Vorzeichen wird mit hoher Wahrscheinlichkeit der Abtastwert mit der größten Amplitude dem tatsächlichen Pegelübergang entsprechen. Die übrigen Schwellwertüberschreitungen sind auf Störungen zurückzuführen. Die Schaltung nach Fig. 3 dient nun zur Ermittlung der wahrscheinlich richtigen Pegelübergänge beim Auftreten von Signalstörungen. Das Korrekturregister 10 ermöglicht eine nachträgliche Korrektur des Bitstromes D.

Der Bitstrom D wird über das D-Flip-Flop 15 in das Korrektur-Register 10 eingelesen. Eine Anordnung für das Korrekturregister 10 ist in Fig. 4 dargestellt. Die Länge der beiden Schieberegister 11 und 14 entspricht der maximalen Runlength des Signals, da eventuell erforderliche Pegelübergangsverschiebungen den Abstand der tatsächlichen Pegelübergänge nicht überschreiten. Der Bittransport im Schieberegister 11, das die jeweils letzten m Bits des abgetasteten Bitstromes enthält, erfolgt über EXOR-Gatter 12, die bei Bedarf die Invertierung eines Teils des Bitstroms ermöglichen. Das Register 14 wird bei jedem zunächst ermittelten Pegelübergang taktsynchron zurückgesetzt und zwischen den Pegelübergängen mit dem Bittakt stufenweise gesetzt. Über die AND-Gatter 13 kann die Inventierung der Bits im Schieberegister 11 entsprechend der im Schieberegister 14 gesetzten Stufen ausgelöst werden.

Jeder Pegelübergang des Signals D erzeugt am Ausgang des EXOR-Gatters 16 einen positiven Impuls T von der Dauer eines Bits. Das OR-Gatter 17 bewirkt, daß das Register 5 nicht nur bei der Feststellung einer Abtastwertvergrößerung, sondern auch bei jedem Pegelübergang des Signals D mit dem aktuellen Abtastwert geladen wird.

Das Gatter 18 bewirkt, daß bei Feststellung einer Abtastwertvergrößerung, die nicht mit einem Pegelübergang verbunden ist, die Invertierung einer Reihe von Bits im Korrekturregister 10 erfolgt. Das hierzu erforderlich Signal C wird zur zeitlichen Anpassung mit Hilfe des D-Flip-Flops 19 um ein Bit verzögert.

Das Gatter 20 bewirkt, daß das Register 14 in der Korrekturschaltung 10 bei jedem Pegelübergang T oder bei jeder zwecks Signalkorrektur durchgeführten Pegelübergangsverschiebung zurückgesetzt wird.

Es besteht die Möglichkeit, die Schwelle S automatisch dem Signalpegel und der Signalqualität anzupassen. Eine erhöhte Häufigkeit der Impulse Co bedeutet, daß die Schwelle S zu niedrig eingestellt ist. Eine zu hoch eingestellte Schwelle S bewirkt, daß einige Pegelübergänge nicht mehr erfaßt werden. Dadurch entsteht eine Veränderung der Runlength-Statistik des Signals zugunsten der höheren Runlength-Werte, bzw. es entstehen Überschreitungen der maximalen Runlength eines Runlength-begrenzten Signals. Mit Hilfe einer Logik-Schaltung 21 können diese Informationen für die automatische Optimierung des Schwellwertes S ausgenutzt werden. Über diese Logik-Schaltung kann auch die Referenzspannung V Ref des A/D-Wandlers eingestellt werden. Damit kann ggf. eine automatische Verstärkungsregelung für das Eingangssignal E entfallen.

Bei der hier beschriebenen Schaltung entstehen Bitfehler nur dann, wenn ein durch eine Störung verursachter Wert A größer ist als der Wert des benachbarten Pegelübergangs oder wenn nach einer störungsbedingten Schwellwertüberschreitung eine weitere störungsbedingte Schwellwertüberschreitung mit entgegengesetztem Vorzeichen folgt. Durch eine Schwellwertoptimierung wird dieses Ereignis verhältnismäßig unwahrscheinlich. Somit bewirkt die Schaltung eine Verbesserung der Störsicherheit gegenüber dem einfachen Schwellwertdetektor.

In Fig. 3 kann der aus dem A/D-Wandler 1, den beiden Comparatoren 3 und 4 und dem Register 5 bestehende Schaltungsteil auch als Analogschaltung aufgebaut sein. Der A/D-Wandler und das Register 5 werden dann durch Abtast- und Halteschaltungen ersetzt und die beiden Comparatoren durch analoge Comparatoren mit binärem Ausgang. Ein zusätzlicher Comparator kann dabei zur Ermittlung des Vorzeichens der Abtastwerte dienen, während für die Bildung des Betrags das ternäre Signal E über einen Doppelweggleichrichter geschickt wird. Die übrige Schaltung kann unverändert bleiben.

In den Fig. 3 bis 5 wurde eine Schaltung beschrieben, die bei der Bitstromregenerierung eine Verbesserung der Störsicherheit bewirkt. In der oben genannten Veröffentlichung wird die Verbesserung der Störsicherheit mit einem Viterbi-Detektor erzielt und zwar an einem Partial-Response-Class IV-Signal (PR4).

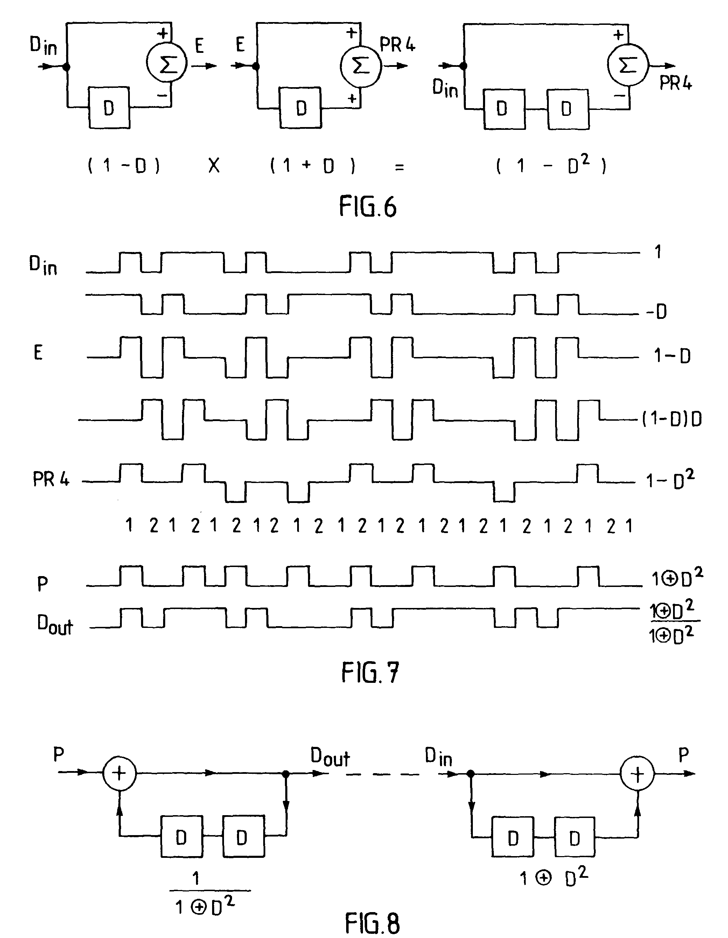

Während in dem in Fig. 3 verwendeten Signal E die hohen Frequenzen besonders stark angehoben sind, ist beim PR4-Signal vor allem der mittlere Frequenzbereich angehoben, wodurch eine besonders gute Störsicherheit erzielt wird. Die Erzeugung des PR4-Signals ist schematisch in Fig. 6 und 7 erläutert. Das Signal E in Fig. 3 entspricht einem Signal, das aus dem Bitstrom Din durch die Übertragungsfunktion 1 - D entstanden ist, wobei D die Signalverzögerung um die Dauer eines Bits ist. Durch Multiplikation mit der Übertragungsfunktion 1 + D entsteht dann das PR4-Signal (siehe Fig. 6 und 7). Es ist erkennbar, daß das PR4-Signal weniger Bandbreite besitzt als ds Signal E.

Das PR4-Signal kann auch direkt mit der in Fig. 6 rechts angegebenen Schaltung mit der Übertragungsfunktion 1 - D² erzeugt werden. Das PR4-Singal ist ein ternäres Signal mit den Pegelwerten 1, 0, -1. Durch Betragsbildung kann aus diesem Signal ein binäres Signal P gewonnen werden. Das Signal P entspricht einem Signal, das mit der in Fig. 8 rechts angegebenen Schaltung aus dem Signal Din erzeugt wurde. In dieser Schaltung wird das Eingangssignal Din mit dem aus 2 Bittakte verzögerten Signal in einem EXOR-Gatter zusammengefaßt. Diese Signalveränderung kann durch eine Vorcodierung mit Hilfe der links in Fig. 8 angegebenen Schaltung aufgehoben werden (Dout in Fig. 7).

In der Schaltung nach Fig. 3 wurde für die Fehlerkorrektur die Besonderheit ausgenutzt, daß im Signal E positive und negative Impulse stets abwechselnd auftreten. Das ist, wie Fig. 7 zeigt, beim PR4-Signal nicht mehr der Fall. Abweichungen von dieser Regel entstehen, wenn die Anzahl von unmittelbar aufeinanderfolgenden Halbwellen der Länge eines Bits im binären Eingangssignal Din gerade ist. Fig. 7 zeigt aber auch, daß das PR4-Signal aus zwei im Zeitmultiplex zusammengefaßten Impulsfolgen besteht, die der obigen Regel entsprechen. In Fig. 7 treten sowohl bei der Folge aller mit "1" bezeichneten Bits als auch bei der Folge aller mit "2" Bits negative und positive Impulse stets abwechselnd auf. Damit besteht die Möglichkeit, auch ein PR4-Signal mit Hilfe einer Korrekturschaltung entsprechend Fig. 3 zu verarbeiten. Das PR4-Signal wird hierzu vor oder hinter dem A/D-Wandler demultiplext und wie bei der Viterbi-Detektion in zwei parallelen Zweigen gemäß Fig. 3 bis 5 verarbeitet. Danach wird das Signal durch einen Multiplexer wieder zusammengefaßt.

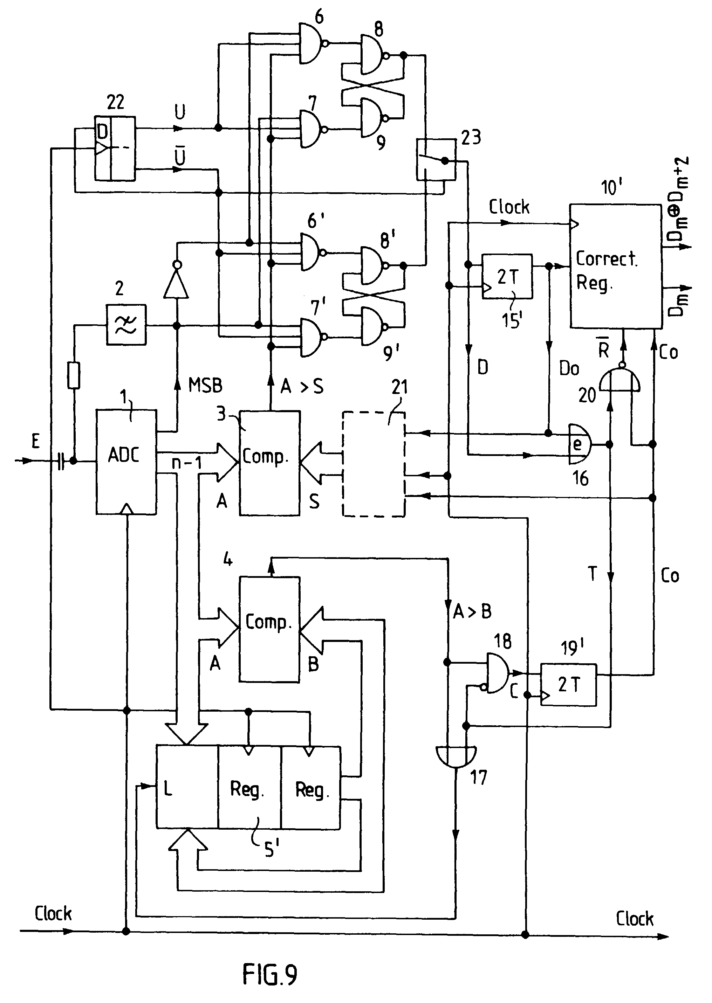

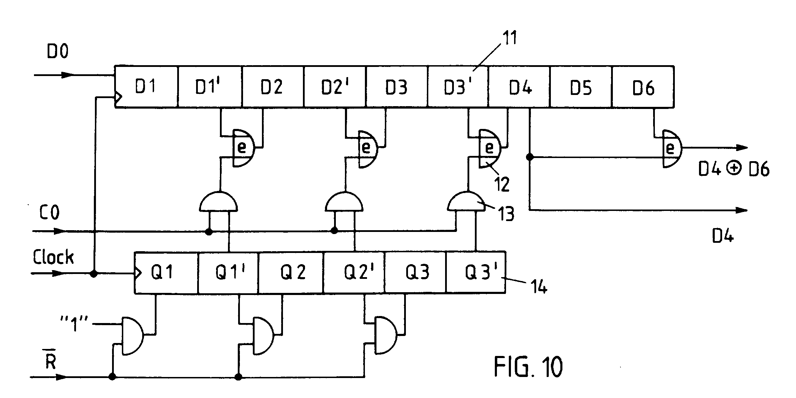

Mit einer Schaltung gemäß Fig. 9 und 10 kann das PR4-Signal auch direkt im Zeitmultiplex verarbeitet werden. Der Mehraufwand gegenüber der Verarbeitungsschaltung für das Signal E besteht dann lediglich in folgendem: Das RS-Flip Flop 6 bis 9 ist doppelt vorhanden. Die Verzögerung im Register 5 sowie an den Stellen 15 und 19 beträgt jeweils 2 Bittakte, d.h. es sind je Signalweg zwei mit dem Bittakt getastete D-Flip Flop hintereinandergeschaltet. Das Flip Flop 22 erzeugt die Umschaltspannung U, die dafür sorgt, daß die Eingänge der RS-Flip Flop 8, 9 und 8', 9' bitweise abwechselnd aktiviert werden und daß die Ausgangsspannungen der RS-Flip Flop 8, 9 und 8', 9' der weiteren Verarbeitungsschaltung bitweise abwechselnd über den Umschalter 23 zugeführt werden.

Beim Korrekturregister 10 verringert sich sogar der Aufwand, da nur jede zweite Stufe des Schieberegisters 11 über ein EXOR-Gatter an die folgende Stufe gekoppelt ist. Beim Register 14 wird ebenfalls nur jede zweite Stufe synchron zurückgesetzt.

Das in Fig. 10 dargestellte Korrekturregister 10' besitzt drei Korrekturstufen. Es kann daher Signalhalbwellen bis zu einer Runlength von 4 Doppelbits, d.h. 8 Bit korrigieren. Das Signalbeispiel von Fig. 7 zeigt, daß in den aus geradzahligen bzw. ungeradzahligen Abtastwerten des PR4-Signals gebildeten Teilsignalen Runlength-Vergrößerungen entstehen können. Es ist jedoch nicht unbedingt nötig, die Länge des Korrekturregisters dementsprechend zu erhöhen. Da die Mehrzahl der zu korrigierenden Pegelübergangsverschiebungen nur wenige Bit beträgt, kann schon mit einem verhältnismäßig kurzen Korrekturregister eine gute Korrekturwirkung erzielt werden.

Der Impulsabstand in den beiden Teilsignalen 1 und 2 des PR4-Signals (Fig. 7) bestimmt die Dauer einer Fehlerfortpflanzung infolge einer Fehlentscheidung. Eine Fehlerfortpflanzung wird in jedem Fall mit dem nächsten richtig erkannten Pegelübergang beendet.

Die Schaltung gemäß Fig. 9 und 10 bewirkt eine Wiederherstellung des Bitmusters Din, das ist z.B. das Bitmuster auf einem Aufzeichnungsträger. Falls dieses Bitmuster durch eine Vorcodierung erzeugt wurde z.B. gemäß Fig. 8, links, dann muß das ursprüngliche Bitmuster durch eine zusätzliche Umcodierung (gemäß Fig. 8 rechts) wiederhergestellt werden. Wie Fig. 10 zeigt, kann diese Umcodierungs-Schaltung mit dem Korrekturregister kombiniert werden.

Die Umcodierung gemäß Fig. 8 rechts erzeugt aus einem fehlerhaften Bit lediglich einen doppelten Bitfehler, verursacht also praktisch keine Fehlerfortpflanzung. Die Schaltung nach Fig. 9 und 10 ist daher sowohl für Signale mit als auch ohne Vorcodierung geeignet. Dagegen erzeugen die bekannten Detektionsschaltungen für PR4-Signale aus dem Signal Din das Signal P. Um das Signal Din zu erhalten, müßte die links in Fig. 8 dargestellte Umcodierungsschaltung der Detektionsschaltung nachgeschaltet werden. Diese Schaltung verursacht jedoch schon bei einem einzigen Bitfehler eine unbegrenzte Fehlerfortpflanzung. Daher ist es üblich, diese Umcodierung als Vorcodierung vor der Signalübertragung einzusetzen. Die bekannten Signalübertragungseinrichtungen mit PR4-Detektion erfordern diese Vorcodierung. Dageben ist das PR4-Detektionsverfahren gemäß Fig. 9 und 10 von der Vorcodierung unabhängig. Das bedeutet, daß dieses Verfahren auch für Übertragungscodes, die keine 2T-Vorcodierung gemäß Fig. 8, links benutzen, anwendbar ist. Derartige Übertragungscodes werden z.B. bei der CD und bei R-DAT verwendet.

## Patentansprüche

1. Verfahren zur Regenerierung des binären Bitstromes aus einem ternären Signal (E), das durch Abtastung einer binären Aufzeichnungsspur gewonnen ist und aus Impulsen besteht, die bezüglich einer Mittellinie abwechselnd positiv und negativ gerichtet sind, wobei aus den Impulsen mit Hilfe eines mit dem regenerierten Bittakt getakteten A/D-Wandlers (1) Abtastwerte gewonnen werden, wobei für die Abtastwerte der positiven und negativen Impulse je ein Schwellwert (S) besteht, **dadurch gekennzeichnet,** daß jede Schwellwertüberschreitung , deren Vorzeichen gegenüber der vorhergehenden Schwellwertüberschreitung geändert ist, zunächst als Pegelübergang des binären Bitstromes gewertet wird, und daß bei mehreren aufeinanderfolgenden Überschreitungen mit gleichem Vorzeichen der Abtastwert mit der größten Schwellwertüberschreitung die endgültige Lage des Pegelüberganges bestimmt.

2. Verfahren nach Anspruch 1, wobei im Ausgangscode des A/D-Wandlers (1) das erste Bit (MSB) das Vorzeichen und die restlichen Bits den Betrag der Abtastwerte angeben (Tab. 1).

3. Verfahren nach einem der Ansprüche 1 oder 2, wobei die Vorspannung am Analogeingang des A/D-Wandlers (1) mit Hilfe des ersten Bits (MSB) so geregelt ist, daß positive und negative Abtastwerte etwa mit gleicher Häufigkeit auftreten.

4. Verfahren nach einem der Ansprüche 1 bis 3, wobei zur Regenerierung des binären Bitstromes aus einem ternären Signal (PR4), das einem Signal entspricht, das durch Addition zweier um eine Bitdauer gegeneinander verschobener gleicher Signale (E) entstanden ist, die aus Impulsen bestehen, die bezüglich einer Mittellinie abwechselnd positiv und negativ gerichtet sind, durch Demultiplexen der Abtastwerte des ternären Signals (PR4) zwei Wertefolgen gebildet werden, die Signalen entsprechen, deren Impulse bezüglich einer Mittellinie abwechselnd positiv und negativ gerichtet sind, daß jede Abtastfolge in einem Verfahren gemäß einem der Ansprüche 1 bis 3 verarbeitet wird, und daß danach die einzelnen Signale in einem Multiplexer wieder zusammengefaßt werden.

5. Verfahren nach einem der Ansprüche 1 bis 3, wobei zur Regenerierung des binären Bitstromes aus einem ternären Signal (PR4), das einem Signal entspricht, das durch Addition zweier um eine Bitdauer gegeneinander verschobener gleicher Signale (E) entstanden ist, die aus Impulsen bestehen, die bezüglich einer Mittellinie abwechselnd positiv und negativ gerichtet sind, die Verarbeitung der Abtastwerte zweier Wertefolgen in einem Verfahren, das einem der Ansprüche 1 bis 3 entspricht, im Zeitmultiplex erfolgt.

6. Schaltung zur Ausführung eines Verfahrens nach einem der Ansprüche 1 bis 5 zur Regenerierung des binären Bitstromes aus einem ternären Signal (E), das durch Abtastung einer binären Aufzeichnungsspur gewonnen ist und aus Impulsen besteht, die bezüglich einer Mittellinie abwechselnd positiv und negativ gerichtet sind, wobei aus den Impulsen mit Hilfe eines mit dem regenerierten Bittakt getakteten A/D-Wandlers (1) Abtastwerte gewonnen werden, wobei der einem zweiten Komparator zur Ermittlung der Schwellwertüberschreitungen (3) zugeführte Schwellwert (S) mit Hilfe einer Logikschaltung (21) dem zu verarbeitenden Signal (E) angepaßt wird, **dadurch gekennzeichnet,** daß zur Ermittlung der größten Schwellwertüberschreitung, die die Lage des Pegelübergangs bestimmt, in einem ersten Komparator (4) der Betrag (A) des aktuellen Abtastwertes mit dem im Register (5) gespeicherten Betrag B verglichen wird und bei jeder Schwellwertüberschreitung mit Vorzeichenwechsel sowie bei jeder Feststellung einer Betragserhöhung das Register (5) mit dem Betrag des aktuellen Abtastwertes (A) geladen wird.

7. Schaltung nach Anspruch 6, wobei zur Erzeugung des vorläufigen binären Bitstromes (D) ein Flip-Flop (8, 9) vorgesehen ist, dessen Ausgang bei Schwellwertüberschreitungen auf den dem Vorzeichen entsprechenden Wert gesetzt wird.

8. Schaltung nach Anspruch 7, wobei der vorläufige Bitstrom (D) in ein mit dem Bittakt getaktetes Korrekturregister (10) eingelesen wird, dessen Länge etwa der maximalen Runlength des zu regenerierenden Bitstromes entspricht.

9. Schaltung nach Anspruch 8, wobei in dem Korrekturregister der Bittransport in einem ersten Register (11) über EXOR-Gatter (12) erfolgt, daß ein zweites Schieberegister (14) vorgesehen ist, das mit dem Bittakt stufenweise gesetzt wird und bei jeder Schwellwertüberschreitung mit geänderten Vorzeichen zurückgesetzt wird, und daß bei Abtastwertvergrößerungen ohne Vorzeichenwechsel die Bits im ersten Register entsprechend den im zweiten Register gesetzten Stufen über die EXOR-Gatter invertiert werden, und das zweite Register ebenfalls zurückgesetzt wird.

10. Schaltung nach Anspruch 6, wobei die Logikschaltung (21) die Korrekturhäufigkeit (Co) und/oder die Runlength-Werte des unkorrigierten Bitstromes (D) verarbeitet.

11. Schaltung nach Anspruch 10, wobei die Logikschaltung die Referenzspannung (V Ref) des A/D-Wandlers einstellt.

12. Schaltung nach einem oder mehreren der Ansprüche 6 bis 11, wobei der A/D-Wandler (1) und das Register (5) durch Abtast- und Halteschaltungen ersetzt sind, und daß die Komparatoren (3, 4) zur Ermittlung der Schwellwertüberschreitungen und zur Ermittlung der maximalen Schwellwertüberschreitung analoge Eingänge und binäre Ausgänge besitzen.

13. Schaltung nach Anspruch 6 zur Regenerierung des binären Bitstromes aus einem ternären Signal (PR4), das einem Signal entspricht, das durch Addition zweier um eine Bitdauer gegeneinander verschobener gleicher Signale (E) entstanden ist, die aus Impulsen bestehen, die bezüglich einer Mittellinie abwechselnd positiv und negativ gerichtet sind, wobei zur Erzeugung des vorläufigen binären Bitstromes (D) für die Verarbeitung der geradzahligen und ungeradzahligen Abtastwerte im Zeitmultiplex zwei RS-Flip Flops (8, 9) vorhanden sind, deren Ausgänge bei Schwellwertüberschreitungen auf den dem Vorzeichen entsprechenden Wert gesetzt werden.

14. Schaltung nach Anspruch 13, wobei der vorläufige Bitstrom (D) in ein mit dem Bittakt getaktetes Korrekturregister (10') eingelesen wird, dessen Länge etwa der maximalen Runlength des zu regenerierenden Bitstromes entspricht, wobei in einem ersten Schieberegister (11) der Bittransport bei jeder zweiten Stufe über ein EXOR-Gatter (12) erfolgt, und daß ein zweites Schieberegister (14) vorgesehen ist, das mit jedem Bittakt stufenweise gesetzt wird, daß entsprechend der gesetzten Stufen des zweiten Registers (14) über die EXOR-Gatter (12) ein Invertieren der Bits im ersten Register durchführbar ist, und das Rücksetzen des zweiten Registers synchron für jede zweite Stufe erfolgt (Fig. 10).

## Claims

1. A method of regenerating the binary bit stream from a ternary signal (E) which has been obtained by sampling a binary recording track and consists of pulses which are alternately positively and negatively directed relative to a central line, where sample values are obtained from the pulses with the aid of an A/D converter (1) clocked with the regenerated bit clock signal, where a threshold value (S) in each case exists for the sample values of the positive and negative pulses, characterised in that each threshold value overshooting whose sign has changed compared to the previous threshold value overshooting is initially evaluated as a level transition of the binary bit stream, and that in the case of a plurality of consecutive overshootings with the same sign, the sample value with the greatest threshold value overshooting defines the final position of the level transition.

2. A method according to Claim 1, where in the output code of the A/D converter (1) the first bit (MSB) indicates the sign of the sample values and the remaining bits indicate the amount of the sample values (Tab. 1).

3. A method according to one of Claims 1 or 2, where the bias voltage at the analogue input of the A/D converter (1) is regulated with the aid of the first bit (MSB) in such manner that positive and negative sample values occur approximately with the same frequency.

4. A method according to one of Claims 1 to 3, where for the regeneration of the binary bit stream from a ternary signal (PR4), which corresponds to a signal which has been formed by the addition of two identical signals (E) offset from one another by the duration of one bit and consisting of pulses which are alternately positively and negatively directed relative to a central line, by demultiplexing of the sample values of the ternary signal (PR4) two value sequences are formed which correspond to signals whose pulses are alternately positively and negatively directed relative to a central line, that each sample sequence is processed in a process according to one of Claims 1 to 3, and that then the individual signals are recombined in a multiplexer.

5. A method according to one of Claims 1 to 3, where for the regeneration of the binary bit stream from a ternary signal (PR4) which corresponds to a signal which has been formed by the addition of two identical signals (E) offset relative to one another by the duration of one bit and consisting of pulses which are alternately positively and negatively directed relative to a central line, the processing of the sample values of two value sequences takes place in accordance with time division multiplex in a process corresponding to one of Claims 1 to 3.

6. A circuit for the implementation of a process according to one of Claims 1 to 5 for the regeneration of the binary bit stream from a ternary signal (E), which has been obtained by sampling a binary recording track and consists of pulses which are alternately positively and negatively directed relative to a central line, where sample values are obtained from the pulses with the aid of an A/D converter (1) clocked with the regenerated bit clock signal, where the threshold value (S) fed to a second comparator for detecting the threshold value overshootings (3) is adapted with the aid of a logic circuit (21) to the signal (E) to be processed, characterised in that for the detection of the greatest threshold value overshooting, which defines the position of the level transition, in a first comparator (4) the amount of the current sample value is compared with the amount B stored in the register (5) and in the case of every threshold value overshooting with a change of sign and in the case of every determination of an increase in amount the register (5) is loaded with the amount of the current sample value (A).

7. A circuit according to Claim 6, where a flip-flop (8, 9) is provided for the generation of the preliminary binary bit stream (D) and where in the case of threshold value overshootings the output of said flip-flop (8, 9) is set at the value corresponding to the sign.

8. A circuit according to Claim 7, where the preliminary bit stream (D) is input into a correction register (10) clocked with the bit clock signal and where the length of said correction register corresponds approximately to the maximum run length of the bit stream to be regenerated.

9. A circuit according to Claim 8, where in the correction register the bit transportation takes place in a first register (11) via EXCLUSIVE-OR gates (12), that a second shift register (14) is provided which is set in stepped manner with the bit clock signal and is reset in the case of every threshold value overshooting with a changed sign, and that in the case of sample value increases with no change of sign the bits in the first register are inverted via the EXCLUSIVE-OR gates in accordance with the stages set in the second register, and the second register is likewise reset.

10. A circuit according to Claim 6, where the logic circuit (21) processes the correction frequency (Co) and/or the run length values of the uncorrected bit stream (D).

11. A circuit according to Claim 10, where the logic circuit adjusts the reference voltage (V Ref) of the A/D converter.

12. A circuit according to one or more of Claims 6 to 11, where the A/D converter (1) and the register (5) are replaced by sample- and hold circuits, and that the comparators (3, 4) for detecting the threshold value overshootings and for detecting the maximum threshold value overshooting have analogue inputs and binary outputs.

13. A circuit according to Claim 6 for regenerating the binary bit stream from a ternary signal (PR4), which corresponds to a signal which has been formed by the addition of two identical signals (E) offset relative to one another by the duration of one bit and consisting of pulses which are alternately positively and negatively directed relative to a central line, where for the generation of the preliminary binary bit stream (D) two RS flip-flops (8, 9) are provided for the processing of the even-numbered and odd-numbered sample values in accordance with time division multiplex and where in the event of threshold value overshootings the outputs of said RS flip-flops (8, 9) are set at the value corresponding to the sign.

14. A circuit according to Claim 13, where the preliminary bit stream (D) is input into a correction register (10') which is clocked with the bit clock signal and whose length corresponds approximately to the maximum run length of the bit stream to be regenerated, where in a first shift register (11) the bit transportation takes place via an EXCLUSIVE-OR gate (12) in the case of every second stage, and that a second shift register (14) is provided which is set in stepped manner with each bit clock signal, that an inversion of the bits in the first register can be effected via the EXCLUSIVE-OR gates (12) in accordance with the set stages of the second register (14), and that the resetting of the second register takes place in a synchronous manner for every second stage (Fig. 10).

## Revendications

1. Procédé de régénération du flux d'information binaire à partir d'un signal ternaire (E) obtenu par échantillonnage d'une piste d'enregistrement binaire et composé d'impulsions qui évoluent alternativement en positif ou en négatif par rapport à une ligne médiane, dans lequel des valeurs d'échantillonnage sont obtenues à partir des impulsions à l'aide d'un convertisseur analogique/numérique (1) cadencé par une cadence de bits régénérée, une valeur de seuil (S) existant pour chaque valeur d'échantillonnage des impulsions positives et négatives, caractérisé en ce que chaque dépassement de seuil dont le signe est différent du dépassement de seuil précédent, est tout d'abord considéré comme un changement de niveau du flux d'information binaire et que pour plusieurs dépassements de seuil consécutifs avec le même signe, la valeur d'échantillonnage présentant le dépassement de seuil le plus élevé détermine la position définitive du changement de niveau.

2. Procédé selon revendication 1 dans lequel le bit de poids fort détermine le signe et les bits restants déterminent la valeur absolue de la valeur d'échantillonnage dans le code de sortie du convertisseur analogique/numérique (1) (voir tableau 1).

3. Procédé selon revendication 1 ou 2 dans lequel la tension d'amorçage au niveau de l'entrée analogique du convertisseur analogique/numérique (1) est réglée à l'aide du bit de poids fort, de sorte que les valeurs d'échantillonnage positives et négatives apparaissent à des fréquences comparables.

4. Procédé selon revendication 1, 2 ou 3 dans lequel deux séquences de valeurs sont créées par démultiplexage de la valeur d'échantillonnage d'un signal ternaire (PR4) pour la régénération du flux d'information binaire à partir de ce signal ternaire (PR4) correspondant à un signal produit par addition de signaux binaires (E) retardés les uns par rapport aux autres de la durée d'un bit et constitués d'impulsions qui évoluent alternativement en positif ou en négatif par rapport à une ligne médiane. Ces séquences de valeurs correspondent à des signaux dont les impulsions évoluent alternativement en positif ou en négatif par rapport à une ligne médiane. De sorte que chaque séquence est traitée dans un procédé selon l'une des revendications 1 à 3 et les signaux individuels regroupés dans un multiplexeur.

5. Procédé selon revendication 1, 2 ou 3 dans lequel le traitement des valeurs d'échantillonnage des séquences de valeurs binaires s'effectue en multiplexage temporel dans un procédé selon l'une des revendications 1 à 3 pour la régénération du flux d'information binaire à partir d'un signal ternaire (PR4) correspondant à un signal produit par addition de signaux binaires (E) retardés les uns par rapport aux autres de la durée d'un bit et constitués d'impulsions qui évoluent alternativement en positif ou en négatif par rapport à une ligne médiane. Ces séquences de valeurs correspondent à des signaux dont les impulsions évoluent alternativement en positif ou en négatif par rapport à une ligne médiane. De sorte que chaque séquence est traitée dans un procédé selon l'une des revendications 1 à 3 et les signaux individuels regroupés dans un multiplexeur.

6. Circuit permettant d'exécuter un procédé selon l'une des revendications 1 à 5 pour régénération du flux d'information binaire à partir d'un signal ternaire (E) obtenu par échantillonnage d'une piste d'enregistrement binaire et constitué d'impulsions qui évoluent alternativement en positif ou en négatif par rapport à une ligne médiane, dans lequel des valeurs d'échantillonnage sont obtenues à partir des impulsions à l'aide d'un convertisseur analogique/numérique (1) cadencé par une cadence de bits régénérée et dans lequel la valeur de seuil (S) fournie par un deuxième comparateur pour déterminer les dépassements de seuil (3) est adaptée à l'aide d'un circuit logique (21) au signal (E) à traiter. Caractérisé en ce que, pour la détection du dépassement de seuil le plus fort déterminant la position du changement de niveau, la valeur absolue (A) des valeurs d'échantillonnage actuelles est comparée à la valeur absolue (B) stockée dans le registre (5) et qu'à chaque dépassement de seuil avec changement de signe, ainsi qu'à chaque détection d'une augmentation de la valeur absolue, la valeur absolue (A) des valeurs d'échantillonnage actuelles est chargée dans le registre (5).

7. Circuit selon revendication 6 dans lequel un flip-flop (8, 9) est prévu pour la génération du flux d'information binaire (D) provisoire. En cas de dépassement de seuil, la sortie de ce flip-flop est réglée sur la valeur correspondant au signe.

8. Circuit selon revendication 7 dans lequel le flux d'information binaire (D) provisoire est lu dans un registre de correction (10) cadencé par la cadence de bits. La longueur du registre correspond à peu près à la longueur de signal maximale du flux d'information binaire à régénérer.

9. Circuit selon revendication 8 dans lequel le transport binaire dans le registre de correction s'effectue via la porte EXOR (12) dans un premier registre (11). Un second registre à décalage (14) est prévu. Il est réglé par couche avec la cadence de bits et réinitialisé à chaque dépassement de seuil avec changement de signe. En cas d'augmentation de la valeur d'échantillonnage sans changement de signe, les bits du premier registre sont inversés via la porte EXOR en fonction des couches définies dans le deuxième registre, le second registre étant également réinitialisé.

10. Circuit selon revendication 6 dans lequel le circuit logique (21) traite la fréquence de correction (Co) et/ou les longueurs de signal du flux d'information binaire non corrigé (D).

11. Circuit selon revendication 10 dans lequel le circuit logique règle la tension de référence (V ref) du convertisseur analogique/numérique.

12. Circuit selon une ou plusieurs revendications 6 à 11 dans lequel le convertisseur analogique/numérique et le registre (5) sont remplacés par des échantillonneurs bloqueurs.
Les comparateurs (3, 4) de détection des dépassements de seuil et de détection du dépassement de seuil maximal possèdent des entrées analogiques et des sorties binaires.

13. Circuit selon revendication 6 pour régénération du flux d'information binaire à partir d'un signal ternaire (PR4) correspondant à un signal produit par addition de signaux binaires (E) retardés les uns par rapport aux autres de la durée d'un bit et constitués d'impulsions qui évoluent alternativement en positif ou en négatif par rapport à une ligne médiane. Deux flip-flops RS (8, 9) sont prévus pour la génération du flux d'information binaire provisoire (5) destiné au traitement des valeurs d'échantillonnage paires et impaires en multiplexage temporel. En cas de dépassement de seuil, les sorties de ces flip-flops sont réglées sur la valeur correspondant au signe.

14. Circuit selon revendication 13 dans lequel le flux d'information binaire provisoire (D) est lu dans un registre de correction (10) cadencé par la cadence de bits. La longueur du registre correspond à peu près à la longueur de signal maximale du flux d'information binaire à régénérer. Le transport binaire s'effectue à raison d'une couche sur deux via la porte EXOR (12) dans un premier registre (11). Un second registre à décalage (14) est prévu. Il est réglé par couche avec la cadence de bits. Une inversion des bits du premier registre peut être effectuée via la porte EXOR (12) en fonction des couches définies dans le deuxième registre (14). La réinitialisation du deuxième registre s'effectue de façon synchrone à raison d'une couche sur deux (voir figure 10).
